# EUROPÄISCHE PATENTANMELDUNG

(11) **EP 2 219 211 A1**
(43) Veröffentlichungstag der Anmeldung: **18.08.2010**
(21) Anmeldenummer: 09016026.8
(22) Anmeldetag: 24.12.2009
(51) Int. Cl.: H01L 21/48, H01L 23/373

(54) **Substrat zur Aufnahme mindestens eines Bauelements und Verfahren zur Herstellung eines Substrats**

(30) Priorität: 16.02.2009 DE 102009000883
(71) Anmelder: SEMIKRON Elektronik GmbH & Co. KG, 90431 Nürnberg (DE)
(72) Erfinder: Braml, Heiko, Dr., 91346 Wiesenttal (DE); Fey, Tobias, Dr., 91058 Erlangen (DE); Göbl, Christian, 90441 Nürnberg (DE); Sagebaum, Ulrich, 90408 Nürnberg (DE)

(57) **Zusammenfassung**

Die Erfindung ein Substrat zur Aufnahme zumindest eines Bauelements (3), insbesondere eines Leistungshalbleiters, bei dem ein aus einem elektrisch isolierenden Material hergestellter Substratkörper (1) auf zumindest einer Vorder- und/oder einer gegenüberliegenden Rückseite mit einer elektrisch leitfähigen Schicht (2) versehen ist. Zur Vereinfachung der Herstellung eines eine hohe Wärmeleitfähigkeit λ aufweisenden Substrats wird erfindungsgemäß vorgeschlagen, dass der Substratkörper (1) eine aus einem präkeramischen Polymer gebildete duroplastische Matrix aufweist.

## Beschreibung

Die Erfindung betrifft ein Substrat nach dem Oberbegriff des Anspruchs 1. Sie betrifft ferner ein Verfahren zur Herstellung eines Substrats.

Nach dem Stand der Technik sind Substrate zur Aufnahme elektrischer oder elektronischer Bauelemente allgemein bekannt. Derartige Substrate bestehen im Allgemeinen aus einer aus einem elektrisch isolierenden Material hergestellten Platte, welche zumindest auf einer Vorder- und/oder einer gegenüberliegenden Rückseite mit einer elektrisch leitfähigen Schicht versehen ist. Die Platte kann beispielsweise aus einem elektrisch isolierenden Kunststoff oder einer Keramik hergestellt sein. Insbesondere zur Herstellung von mit Leistungshalbleitern bestückten Modulen werden nach dem Stand der Technik beispielsweise DCB-Substrate eingesetzt. Dabei wird als elektrischer Isolator eine aus Aluminiumoxid oder Aluminiumnitrit hergestellte Platte verwendet. Darauf sind Leiterbahnen in einem Hochtemperatur-Schmelz- und Diffusionsprozess aus reinem Kupfer aufgebracht. Solche DCB-Substrate zeichnen sich durch eine hohe Wärmeableitfähigkeit und Temperaturbeständigkeit aus.

Die Herstellung von DCB-Substraten ist gleichwohl aufwändig und teuer. Bedingt durch die hohen Temperaturen bei der Herstellung kann eine Durchbiegung solcher Substrate nicht immer vermieden werden. Das kann in der weiteren Verarbeitungskette zu einem Bruch des DCB-Substrats führen. Abgesehen davon können insbesondere herkömmliche DCB-Substrate lediglich in plattenförmiger Ausgestaltung, nicht jedoch in beliebigen dreidimensionalen Formen hergestellt werden.

Aufgabe der Erfindung ist es, die Nachteile nach dem Stand der Technik zu beseitigen. Es soll insbesondere ein einfach und kostengünstig herstellbares Substrat angegeben werden, welches eine hohe Wärmeleitfähigkeit λ aufweist. Nach einem weiteren Ziel der Erfindung soll das Substrat in einer Vielzahl dreidimensionaler Formen herstellbar sein. Ferner soll ein Verfahren zur Herstellung eines solchen Substrats angegeben werden.

Diese Aufgaben werden durch die Merkmale der Ansprüche 1 und 9 gelöst. Zweckmäßige Ausgestaltungen der Erfindung ergeben sich aus den Merkmalen der Ansprüche 2 bis 8 und 10 bis 21.

Nach Maßgabe der Erfindung ist vorgesehen, dass der Substratkörper eine aus einem präkeramischen Polymer gebildete duroplastische Matrix aufweist. Der vorgeschlagene Substratkörper ist elektrisch isolierend. Er weist eine hervorragende Wärmeleitfähigkeit A auf. Ein weiterer Vorteil des vorgeschlagenen Substratkörpers ist dessen hohe Temperaturbeständigkeit. Er hält Betriebstemperaturen von bis zu 300°C stand. Der vorgeschlagene Substratkörper lässt sich überdies einfach und kostengünstig herstellen. Es ist möglich, den Substratkörper in einer Vielzahl dreidimensionaler Formen herzustellen.

Unter dem Begriff "präkeramisches Polymer" wird ein Polymer verstanden, welches z. B. mit zunehmender Temperatur zunächst in einen gelartigen und nachfolgend in einen duroplastischen Zustand übergeht. Im duroplastischen Zustand weist ein präkeramisches Polymer in der Regel eine Temperaturbeständigkeit von bis zu 300°C auf. Bei einer weiteren Temperaturerhöhung können aus präkeramischen Polymeren keramische Werkstoffe hergestellt werden. Zu präkeramischen Polymeren gehören beispielsweise Polysilane, Polycarbosilane und Polyorganosiloxan.

Nach einer vorteilhaften Ausgestaltung der Erfindung ist vorgesehen, dass das präkeramische Polymer mit einem Füllgrad von bis zu 95 Vol.% mit einem Füllstoff gefüllt ist. Damit kann insbesondere die Wärmeleitfähigkeit λ des unter Verwendung des präkeramischen Polymers hergestellten Substratkörpers erhöht werden.

Zweckmäßigerweise handelt es sich bei dem Füllstoff um ein aus einem keramischen Material gebildetes Pulver mit einer mittleren Korngröße im Bereich von 0,5 bis 200 µm. Das vorgeschlagene keramische Material ist elektrisch isolierend und weitgehend inert. Dessen Zusatz führt insbesondere nicht zu unerwünschten chemischen Reaktionen mit dem präkeramischen Material. Die vorgeschlagene mittlere Korngröße ermöglicht ein Vergießen oder Spritzen des gefüllten präkeramischen Polymers mit herkömmlichen Vorrichtungen.

Die Wärmeleitfähigkeit λ des keramischen Materials ist zweckmäßigerweise bei Raumtemperatur größer als 10 W/mK, vorzugsweise größer als 20 W/mK. Je nach Füllgrad gelingt es damit, die Wärmeleitfähigkeit λ des mit dem keramischen Material gefüllten präkeramischen Polymers auf Werte oberhalb 2 W/mK zu steigern. Damit eignet sich der vorgeschlagene Substratkörper insbesondere zur Herstellung von Substraten für im Betrieb eine relativ große Wärme freisetzende Leistungshalbleiter.

Das keramische Material ist zweckmäßigerweise aus der folgenden Gruppe ausgewählt: BN, SiC, Si₃N₄, AlN, Steatit, Cordierit. Die vorgeschlagenen keramischen Materialien zeichnen sich durch eine hohe Wärmeleitfähigkeit λ aus. Sie sind außerdem elektrisch isolierend.

Weiterhin hat es sich als zweckmäßig erwiesen, dass das präkeramische Polymer aus der folgenden Gruppe ausgewählt ist: Polysiloxan, Polysilazan, Polycarbosilan.

Die elektrisch leitfähige Schicht ist zweckmäßigerweise aus einem Metall, vorzugsweise Aluminium oder Kupfer, oder einem Halbleiter hergestellt. Dabei kann die elektrisch leitfähige Schicht zunächst im Wesentlichen vollflächig die Vorder- und/oder Rückseite des Substratkörpers bedecken. Eine gewünschte Leiterbahnstruktur kann dann nachfolgend mittels herkömmlicher Techniken, beispielsweise Maskieren und nachfolgendes Ätzen, hergestellt werden. Es kann aber auch sein, dass die elektrisch leitfähige Schicht in Form einer vorgegebenen Leiterbahnstruktur vorliegt und dann auf den Substratkörper auflaminiert wird.

Das vorgeschlagene Substrat kann selbstverständlich auch mit Durchkontaktierungen versehen sein. Solche Durchkontaktierungen lassen sich in einfacher und kostengünstiger Weise in den Substratkörper eingießen. Sie können aber auch nachträglich in den duroplastischen Substratkörper eingearbeitet werden.

Nach weiterer Maßgabe der Erfindung ist ein Verfahren zur Herstellung eines Substrats zur Aufnahme zumindest eines Bauelements, insbesondere eines Leistungshalbleiters, vorgesehen, bei dem ein unter Verwendung eines präkeramischen Polymers hergestellter Substratkörper mit einer aus einem elektrisch leitfähigen Material gebildeten Schicht verbunden wird. - Das vorgeschlagene Verfahren ist relativ einfach und kostengünstig durchführbar. Es ist insbesondere nicht erforderlich, einen aufwändigen Sinterprozess durchzuführen und anschließend auf einen damit hergestellten Substratkörper Leiterbahnen mittels eines Hochtemperatur-Schmelz- und Diffusionsprozesses aufzubringen. Gleichwohl zeichnet sich das mit dem erfindungsgemäßen Verfahren hergestellte Substrat durch eine hervorragende Wärmeleitfähigkeit λ aus. Es kann überdies mit einer hohen Formtreue und in einer großen Formvielfalt hergestellt werden.

Unter dem Begriff "Schicht" wird sowohl eine vollflächige Beschichtung einer Vorder- und/oder Rückseite des Substratkörpers als auch lediglich eine abschnittsweise Beschichtung verstanden. Im Falle der abschnittsweisen Beschichtung kann die Schicht in Form einer vorgegebenen Leitbahnstruktur ausgebildet sein.

Nach einer ersten Variante des Verfahrens wird zur Herstellung des Substratkörpers auf zumindest einer Seite der Schicht das präkeramische Polymer aufgetragen und dann in eine duroplastische Form überführt, so dass sich ein fest mit der Schicht verbundenes Substrat ausbildet. Dabei erstreckt sich die Schicht zweckmäßigerweise vollflächig über die Vorder- und/oder Rückseite des Substratkörpers.

Nach einer zweiten Variante des Verfahrens wird ein in duroplastischer Form vorliegender Substratkörper unter Verwendung eines weiteren präkeramischen Polymers mit der aus dem elektrisch leitfähigen Material gebildeten Schicht verbunden. Anschließend wird das weitere präkeramische Polymer in eine duroplastische Form überführt, so dass sich ein fest mit der Schicht verbundenes Substrat ausbildet. Bei der zweiten Variante des Verfahrens wird die Schicht also unter Verwendung eines präkeramischen Polymers mit dem bereits in duroplastischer Form vorliegenden Substratkörper verklebt. Dabei kann nach einer weiteren vorteilhaften Ausgestaltung die elektrisch leitfähige Schicht vor dem Verbinden mit dem Substrat in Form einer vorgegebenen Leiterbahnstruktur vorliegen. Eine solche Leiterbahnstruktur kann beispielsweise mittels Stanzen hergestellt werden. Die Formgebung der Leiterbahnstruktur kann aber auch auf andere Weise, beispielsweise mittels Laserstrahlschneiden oder dgl., hergestellt werden. Falls zunächst eine die Vorder- und/oder die Rückseite des Substratkörpers im Wesentlichen vollflächig überdeckende Schicht angebracht wird, kann daraus beispielsweise mittels Maskieren der Schicht und nachfolgendem Ätzen eine Leiterbahnstruktur hergestellt werden.

Nach einer vorteilhaften Ausgestaltung der Erfindung wird das präkeramische Polymer oder das weitere präkeramische Polymer zum Überführen in die duroplastische Form auf eine Temperatur im Bereich von 100 bis 300°C, vorzugsweise 150 bis 250°C, für eine Haltezeit von 15 bis 300 Minuten, vorzugsweise 30 bis 60 Minuten, aufgeheizt. Selbstverständlich ist es auch möglich, das präkeramische Polymer und/oder das weitere präkeramische Polymer auf andere Weise zu vernetzen und in einen duroplastischen Zustand zu überführen. Beispielsweise kann die Vernetzung durch UV-Strahlung, chemische Zusätze oder dgl., erfolgen.

Wegen der weiteren vorteilhaften Ausgestaltungen des Verfahrens wird auf die zum Substrat beschriebenen Merkmale verwiesen, welche auch Ausgestaltungen des Verfahrens bilden können.

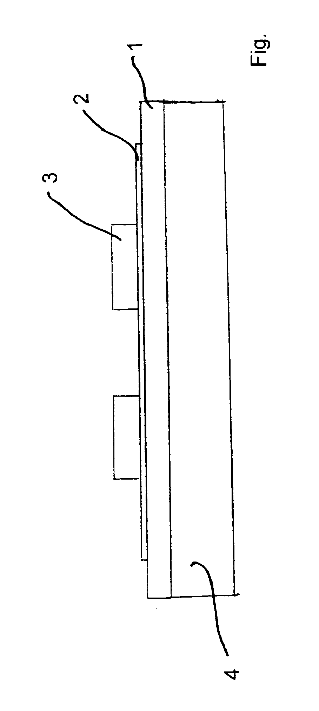

Nachfolgend wird die Erfindung anhand des in der einzigen Figur gezeigten Ausführungsbeispiels näher erläutert. Die einzige Figur zeigt eine schematische Querschnittsansicht durch ein Substrat. Auf einer Vorderseite eines Substratkörpers 1 sind mit dem Bezugszeichen 2 bezeichnete Leiterbahnen angebracht. Mit dem Bezugszeichen 3 sind schematisch Bauelemente, z. B. Leistungshalbleiter, wie Leistungsdioden, Leistungstransistoren oder dgl., bezeichnet, welche mit dem Substrat, z. B. mit einer Lötverbindung, verbunden sind. Eine Rückseite des Substratkörpers 1 kann mit einem, vorzugsweise aus Metall hergestellten, Kühlkörper 4 verbunden sein. Dazu kann der Substratkörper 1 beispielsweise mittels eines präkeramischen Polymers mit dem Kühlkörper 4 verklebt sein.

Der Substratkörper 1 ist aus einem präkeramischen Polymer, beispielsweise Polysiloxan, gebildet, welches zu 60 bis 80 Vol.% mit einem Füllstoff gefüllt ist. Bei dem Füllstoff kann es sich um ein SiC-Pulver mit einer mittleren Korngröße beispielsweise im Bereich von 3 bis 10 µm handeln. Der Substratkörper 1 weist eine hervorragende Wärmeleitfähigkeit λ von mehr als 10 W/mK auf.

Der Substratkörper 1 kann mittels herkömmlicher Guss- oder Spritzgusstechniken hergestellt werden. Dabei liegt das präkeramische Polymer zunächst in flüssiger Form vor. Nach der Formgebung ist es dann erforderlich, das präkeramische Polymer beispielsweise durch eine Wärmebehandlung, UV-Strahlung oder dgl., in einen duroplastischen Zustand zu überführen. Beispielsweise ist es möglich, das präkeramische Polymer mittels Spritzgusstechnik in eine vorgeheizte Form zu spritzen. Das Entformen erfolgt nachdem das präkeramische Polymer in den durplastischen Zustand übergegangen ist.

Die Leiterbahnen 2 können auf einem zuvor hergestellten Substratkörper 1 auflaminiert werden. Als Klebstoff dient dabei zweckmäßigerweise wiederum das präkeramische Polymer, in diesem Fall vorzugsweise allerdings ohne den Zusatz eines Füllstoffs. Zur Verbindung der Leiterbahnen 2 mit dem Substratkörper 1 ist es aber auch möglich, zunächst die Leiterbahnen 2 in eine Form zu legen und nachfolgend das den Substratkörper 1 bildende präkeramische Polymer in die Form zu gießen oder zu spritzen.

### Bezugszeichenliste

- 1: Substratkörper
- 2: Leiterbahn
- 3: Leistungshalbleiter
- 4: Kühlkörper

## Patentansprüche

1. Substrat zur Aufnahme zumindest eines Bauelements (3), insbesondere eines Leistungshalbleiters, bei dem ein aus einem elektrisch isolierenden Material hergestellter Substratkörper (1) auf zumindest einer Vorder- und/oder einer gegenüberliegenden Rückseite mit einer elektrisch leitfähigen Schicht (2) versehen ist,
**dadurch gekennzeichnet, dass**
der Substratkörper (1) eine aus einem präkeramischen Polymer gebildete duroplastische Matrix aufweist.

2. Substrat nach Anspruch 1, wobei das präkeramische Polymer mit einem Füllgrad von bis zu 95 Vol.% mit einem Füllstoff gefüllt ist.

3. Substrat nach einem der vorhergehenden Ansprüche, wobei der Füllstoff ein aus einem keramischen Material gebildetes Pulver mit einer mittleren Korngröße im Bereich von 0,5 bis 500 µm ist.

4. Substrat nach einem der vorhergehenden Ansprüche, wobei die Wärmeleitfähigkeit λ des keramischen Materials bei Raumtemperatur größer als 10 W/mK, vorzugsweise größer als 20 W/mK, ist.

5. Substrat nach einem der vorhergehenden Ansprüche, wobei das keramische Material aus der folgenden Gruppe ausgewählt ist: BN, SiC, Si₃N₄, AlN, Steatit, Cordierit.

6. Substrat nach einem der vorhergehenden Ansprüche, wobei das präkeramische Polymer aus der folgenden Gruppe ausgewählt ist: Polysiloxan, Polysilazan, Polycarbosilan.

7. Substrat nach einem der vorhergehenden Ansprüche, wobei die elektrisch leitfähige Schicht (2) aus einem Metall, vorzugsweise Aluminium oder Kupfer, oder einem Halbleiter hergestellt ist.

8. Substrat nach einem der vorhergehenden Ansprüche, wobei die elektrisch leitfähige Schicht (2) in Form einer vorgegebenen Leiterbahnstruktur vorliegt.

9. Verfahren zur Herstellung eines Substrats zur Aufnahme zumindest eines Bauelements (3), insbesondere eines Leistungshalbleiters, bei dem ein unter Verwendung eines präkeramischen Polymers hergestellter Substratkörper (1) mit einer aus einem elektrisch leitfähigen Material gebildeten Schicht (2) verbunden wird.

10. Verfahren nach Anspruch 9, wobei zur Herstellung des Substratkörpers (1) auf zumindest einer Seite der Schicht (2) das präkeramische Polymer aufgetragen und dann in eine duroplastische Form überführt wird, so dass sich ein fest mit der Schicht (2) verbundenes Substrat ausbildet.

11. Verfahren nach Anspruch 9, wobei ein in duroplastischer Form vorliegender Substratkörper (1) unter Verwendung eines weiteren präkeramischen Polymers mit der aus dem elektrisch leitfähigen Material gebildeten Schicht (2) verbunden wird, und wobei das weitere präkeramische Polymer in eine duroplastische Form überführt wird, so dass sich ein fest mit der Schicht (2) verbundenes Substrat ausbildet.

12. Verfahren nach Anspruch 11, wobei die elektrisch leitfähige Schicht (2) vor dem Verbinden mit dem Substratkörper (1) in Form einer vorgegebenen Leiterbahnstruktur vorliegt.

13. Verfahren nach Anspruch 12, wobei die Leiterbahnstruktur mittels Stanzen hergestellt wird.

14. Verfahren nach einem der Ansprüche 9 bis 12, wobei eine vorgegebene Leiterbahnstruktur mittels Maskieren der Schicht (2) und nachfolgendes Ätzen hergestellt wird.

15. Verfahren nach einem der Ansprüche 9 bis 14, wobei das präkeramische Polymer oder das weitere präkeramische Polymer zum Überführen in die duroplastische Form auf eine Temperatur im Bereich von 100 bis 300°C, vorzugsweise 150 bis 250°C, für eine Haltezeit von 15 bis 300 Minuten, vorzugsweise 30 bis 60 Minuten, aufgeheizt wird.

16. Verfahren nach einem der Ansprüche 10 bis 15, wobei das präkeramische Polymer mit einem Füllgrad von bis zu 95 Vol.% mit einem Füllstoff gefüllt ist.

17. Verfahren nach einem der Ansprüche 10 bis 16, wobei der Füllstoff ein aus einem keramischen Material gebildetes Pulver mit einer mittleren Korngröße im Bereich von 0,5 bis 500 µm ist.

18. Verfahren nach einem der Ansprüche 9 bis 17, wobei die Wärmeleitfähigkeit λ des keramischen Materials bei Raumtemperatur größer als 10 W/mK, vorzugsweise größer als 20 W/mK, ist.

19. Verfahren nach einem der Ansprüche 9 bis 18, wobei das keramische Material aus der folgenden Gruppe ausgewählt ist: BN, SiC, Si₃N₄, AlN, Steatit, Corierit.

20. Verfahren nach einem der Ansprüche 9 bis 19, wobei das präkeramische Polymer und/oder das weitere präkeramischen Polymer aus der folgenden Gruppe ausgewählt ist: Polysiloxan, Polysilazan, Polycarbosilan ist.

21. Verfahren nach einem der Ansprüche 9 bis 20, wobei die elektrisch leitfähige Schicht (2) aus einem Metall, vorzugsweise Aluminium oder Kupfer, oder einem Halbleiter hergestellt ist.
